# EUROPEAN PATENT APPLICATION

(11) **EP 1 184 131 A1**
(43) Date of publication of application: **06.03.2002**
(21) Application number: 01119849.6
(22) Date of filing: 16.08.2001
(51) Int. Cl.: B23Q 3/06, H05K 3/00

(54) **Workholder system for a drilling machine, in particular for printed circuit boards**

(30) Priority: 30.08.2000 IT TO000829
(71) Applicant: PLURITEC ITALIA S.p.A., 28021 Borgomanero (IT)
(72) Inventor: RAHO, Guglielmo, 10023 Chieri (IT)
(74) Representative: Franzolin, Luigi

(57) **Abstract**

The system includes a supporting member (18,28,36) connected to the fixed frame (6) of a drilling machine (5) and supporting at least one pressure member (22,29) activated independently of the feed movement of the spindle (9) to apply local pressure on a pack (8) of boards to be drilled. In the case of a drilling machine in which the worktable (7) supports a number of packs (8) for drilling, and a group of machining heads (12a,12b,...,12n) runs along a cross member (41) of the frame (6), the supporting member (28,36) has two parallel bars (39), each fitted with a number of pressure members (29a,29b,...,29n); and a control unit (16) activates the pressure members (29a,29b,...,29n) closest to the drilling point of each machining head (12a,12b, ...,12n).

## Description

The present invention relates to a workholder system for a drilling machine, in particular for printed circuit boards.

Advanced electronics and computer industries employ an enormous number of printed circuit boards, the processing of which comprises drilling a large number of holes or microholes. For which purpose, the boards are formed into packs, each comprising two plates for supporting and positioning the pack on the drilling machine worktable; and the boards in the pack are drilled simultaneously by a drill fitted to a rotating spindle in turn fitted to the machining head.

The worktable and machining head are movable with respect to each other to select the drilling point on the pack; and the spindle is movable towards the worktable to impart forward motion to the drill, and is normally provided with a workholder device for engaging the board pack prior to engagement by the drill, and for securing the pack to the worktable during the drilling operation.

The workholder device is normally defined by a ring having two lateral arms connected to the machining head by elastic pressure means, such as springs or fluidic cylinders, so that each machining head must be fitted with a specific workholder device and is invariably complex and expensive.

It is an object of the present invention to provide a workholder system for a drilling machine, designed to simplify machining head manufacture, and which provides for maximum efficiency and reliability.

According to the present invention, there is provided a workholder system for a drilling machine, in particular for printed circuit boards, comprising a fixed frame; a worktable; at least one tool spindle; positioning means for moving said spindle and said worktable with respect to each other in two coordinate directions to select a drilling point on the work; feed means activated to move said spindle through a drilling stroke; and workholder means activated to secure the work to said worktable during drilling; characterized in that said workholder means are carried by said frame and are activated independently of said feed means.

A preferred, non-limiting embodiment of the invention will be described by way of example with reference to the accompanying drawings, in which:
Figure 1 shows a schematic front view of a printed circuit board drilling machine featuring a workholder system in accordance with the invention;
Figure 2 shows a schematic partial view of the Figure 1 machine featuring a variation of the workholder system according to the invention;
Figure 3 shows a schematic front view of a further drilling machine featuring a further variation of the workholder system according to the invention;
Figure 4 shows a larger-scale top plan view of a Figure 3 detail;
Figure 5 shows a schematic front view of a multispindle drilling machine featuring the Figure 3 workholder system;
Figure 6 shows a block diagram of a control unit for controlling the Figure 5 workholder system.

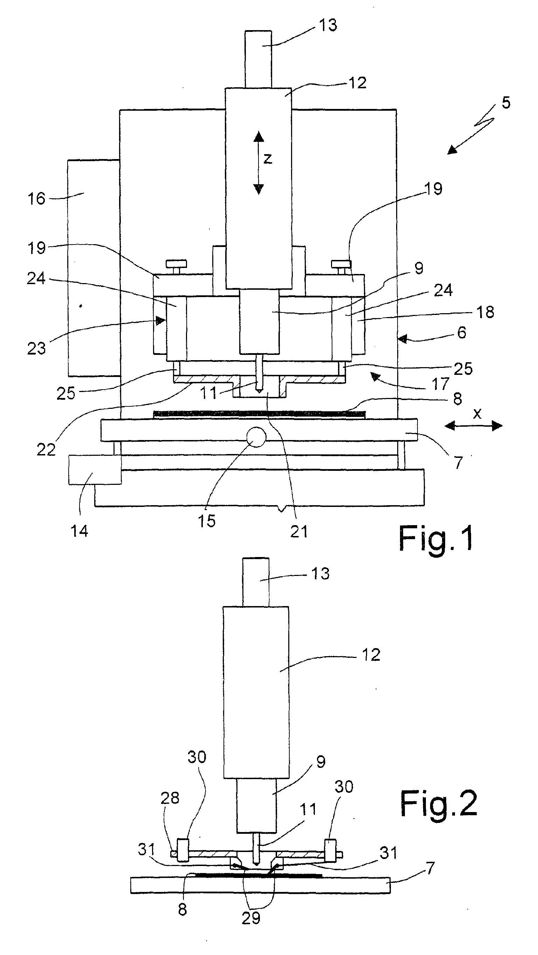

Number 5 in Figure 1 indicates as a whole a printed circuit board drilling machine, which substantially comprises a fixed frame 6; a worktable 7 to which a pack 8 of printed circuit boards for drilling is fixed in known manner; and a rotating tool spindle 9 fitted with a drill 11. As is known, the holes in printed circuit boards are normally arranged in a matrix of rows and columns.

In the Figure 1 embodiment, spindle 9 is fitted to a machining head 12 fixed to frame 6, and has feed means, comprising an electric servomotor 13, for moving spindle 9 towards worktable 7 through a drilling stroke along the usual Z axis. Machine 5 also comprises positioning means for moving spindle 9 and worktable 7 with respect to each other in two coordinate directions, or along two coordinate axes, X and Y to select the drilling point on pack 8.

More specifically, worktable 7 is movable with respect to frame 6 along two perpendicular guides; the positioning means comprise two electric servomotors 14 and 15 for controlling movement along axes X and Y respectively; and servomotors 13, 14 and 15 are controlled, e.g. feedback controlled, by a known electronic control unit 16 on the basis of a pack 8 drilling program.

According to the invention, machine 5 is equipped with a workholder system comprising workholder means 17, which are activated to clamp pack 8 to worktable 7 during drilling, are carried by fixed frame 6, and are activated independently of feed means of spindle 9. In the Figure 1 embodiment, workholder means 17 comprise a supporting member 18 connected adjustably to frame 6, e.g. by known devices 19 for adjusting the distance between supporting member 18 and worktable 7.

Supporting member 18 supports a pressure member 22 having a circular opening 21 aligned with spindle 9. Between supporting member 18 and pressure member 22 are provided actuating means 23, which may be defined by a fluidic device, e.g. comprising a compressed-air cylinder 24 fixed to member 18, and a piston 25 fixed to member 22. The Figure 1 embodiment comprises two devices 24-25 diametrically opposite with respect to the axis of spindle 9 and activated under the control of electronic control unit 16 to cause pressure member 22 clamp pack 8 to worktable 7.

The Figure 1 workholder system operates as follows.

Once the pack 8 of boards is fixed to worktable 7, control unit 16 is operated to first activate servomotors 14 and 15 to align with drill 11 on spindle 9 the point on pack 8 where the first hole is to be drilled, and then activate compressed-air devices 24-25 followed by servomotor 13.

Pistons 25 therefore bring pressure member 22 into contact with pack 8, which is thus pressed elastically on worktable 7, before pack 8 is engaged by drill 11; and servomotor 13 feeds spindle 9 forward to drill pack 8 to the programmed depth.

Pressure member 22 maintains the clamping pressure on pack 8 throughout the drilling operation, regardless of the axial position of spindle 9. And, once drilling is completed, control unit 16 reverses servomotor 13 so that spindle 9 withdraws drill 11 from pack 8; activates devices 24-25 so that member 22 releases pack 8; and again activates servomotors 14 and 15 to select the next drilling point.

Instead of fluidic device/s 24-25, actuating means 23 operating pressure member 22 may be defined by electromagnetic, magnetostrictive or piezoelectric means controlled in known manner by unit 16, in which case, the workholder system operates in the same way as described above.

As will be clear, according to the invention, the workholder system as a whole, defined by supporting member 18, pressure member 22 and actuating means 23, forms part of drilling machine 5, as opposed to machining head 12 of spindle 9. Since the same drilling machine 5 can be fitted with heads 12 mounting different spindles 9, depending on the size of tools 11 used, and since machining head 12 with spindle 9 is a delicate, high-cost assembly with a shorter life than drilling machine 5, the advantage of the workholder system forming part of machine 5, as opposed to machining head 12, is obvious.

In the Figure 2 variation, the workholder supporting member is in the form of a plate 28 also connected to fixed frame 6 by distance-adjusting devices, and having at least two pressure members 29 connected individually to respective actuating means, e.g. to two electromagnets 30, by respective motion transmission means. More specifically, each member 29 is carried by a respective lever 31 activated by respective electromagnet 30 and designed to produce a predetermined force-travel ratio of respective pressure member 29 on pack 8.

The two pressure members 29 may be located at the same or different distances from the axis of tool 11. In the first case, control unit 16 energizes electromagnets 30 simultaneously; in the second case, control unit 16 selects and energizes, each time, the electromagnet 30 controlling the pressure member 29 closest to the drilling point on pack 8, e.g. the one on the right in Figure 2.

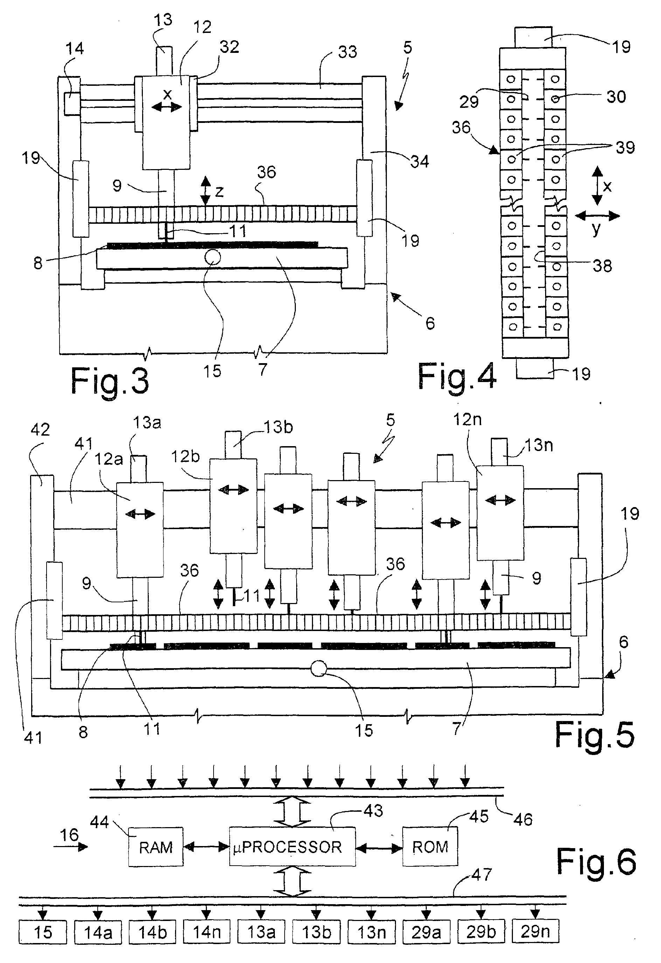

In the Figure 3 variation, the relative movements of spindle 9 and worktable 7 along axes X and Y are performed by spindle 9 and worktable 7 respectively. More specifically, spindle 9 is supported on a carriage 32 moved by the X-axis servomotor 14 along a cross member 33 fitted to two uprights 34 of fixed frame 6 of drilling machine 5; and worktable 7 is moved in one direction by the Y-axis servomotor 15.

With the above structure of machine 5, the workholder system advantageously comprises a plate 36 connected to the two uprights 34 by two distance-adjusting devices 19; and plate 36 has a central opening 38 (Figure 4) aligned with the plane in which the axis of spindle 9 travels along the X axis, so as to form two bars 39 supporting two parallel rows of pressure members, e.g. the same as pressure members 29 in Figure 2.

In this case, drilling is programmed to first set worktable 7 to a row in the hole matrix, carriage 32 of spindle 9 is moved sequentially to select the various drilling points along that row, and control unit 16 is programmed to select the pair of pressure members 29 closest to the drilling point.

In the Figure 5 variation, drilling machine 5 has a number of spindles 9 fitted to respective machining heads 12a, 12b, ..., 12n running independently along a common cross member 41 fixed to two lateral uprights 42; and worktable 7 supports a number of packs 8 of circuit boards, normally equal to the number of spindles 9 on cross member 41, and is movable perpendicularly to cross member 41, as in Figure 3.

In this case, too, the workholder system advantageously comprises a plate 36 forming two bars 39 and connected to the two uprights 42 by two adjusting devices 19; and plate 36 has an opening 38 (Figure 4) forming two bars 39 supporting two parallel rows of pressure members 29.

Control unit 16 (Figure 6) may be defined by a microprocessor 43 associated with a RAM 44 and a ROM 45, and which receives, over an input bus 46, signals indicating the position of worktable 7 and the various machining heads 12a, 12b, ..., 12n, and, over an output bus 47, controls respective servomotors 15, 14a, 14b, ..., 14n and 13a, 13b, ... 13n, and selects and controls the various pairs of pressure members 29a, 29b, ..., 29n.

Drilling is programmed on microprocessor 43 to first set worktable 7 to a row in the matrix, and each spindle 9 is moved sequentially over respective pack 8 to select the various points in that row for drilling in respective pack 8.

On drilling machine 5 in Figure 5, even packs 8 requiring different hole arrangements can be machined simultaneously. To activate the workholder system, microprocessor 43 is programmed to select, for each machining head 12a, 12b, ..., 12n, the pair of pressure members 29a, 29b, ..., 29n closest to the drilling point, throughout the time respective tool 11 engages respective pack 8.

As opposed to independent machining heads 12a, 12b, ..., 12n, as in Figure 5, spindles 9 on cross member 41 may all be fitted to a common carriage and so perform the same drilling program. Finally, in the case of a drilling machine in which the spindles are arranged in two parallel rows, and the worktable supports a corresponding number of packs 8 also arranged in two parallel rows, as described in Italian Patent Application TO97A000869 by the present Applicant, the workholder system may comprise two pairs of bars 39 corresponding to the two rows of spindles 9.

In both the above cases, too, microprocessor 43 is programmed to select, for each machining head 12a, 12b, ..., 12n, the pair of pressure members 29a, 29b, ..., 29n closest to the respective drilling point.

Clearly, further changes may be made to the workholder system as described herein without, however, departing from the scope of the accompanying Claims. For example, microprocessor 43 may be programmed to activate, for each hole to be drilled, a different number of pressure members 29 adjacent to each drilling point.

## Claims

1. A workholder system for a drilling machine, in particular for printed circuit boards, comprising a fixed frame (6); a worktable (7); at least one tool spindle (9); positioning means (14, 15) for moving said spindle (9) and said worktable (7) with respect to each other in two coordinate directions (X, Y) to select a drilling point on the workpiece (8); feed means (13) activated to move said spindle (9), towards said worktable (7), through a drilling stroke; and workholder means (17) activated to secure the workpiece (8) to said worktable (7) during drilling; **characterized in that** said workholder means (17) are carried by said frame (6) and are activated independently of said feed means (13).

2. A system as claimed in Claim 1, **characterized in that** said workholder means (17) comprise at least one supporting member (18, 28, 36) connected to said frame (6); said supporting member (18, 28, 36) supporting at least one pressure member (22, 29) activated to apply local pressure on and press said workpiece (8) against said worktable (7).

3. A system as claimed in Claim 2, **characterized in that** said supporting member (18) is connected to said frame (6) by a device (19) for adjusting the distance between said supporting member (18) and said workpiece (8).

4. A system as claimed in Claim 3, **characterized in that** said pressure member (22) is activated by a fluidic device (23) for applying pressure and carried by said supporting member (18).

5. A system as claimed in Claim 3, **characterized in that** said pressure member (22, 29) is activated by electromagnetic, magnetostrictive or piezoelectric actuating means (30) for applying pressure and carried by said supporting member (28, 36).

6. A system as claimed in Claim 5, **characterized in that** said supporting member (28, 36) supports at least two pressure members (29) activated independently by corresponding actuating means (30).

7. A system as claimed in Claim 6, **characterized in that** said corresponding actuating means (30) are energized selectively by a control unit (16) according to the distance of the corresponding pressure members (29) from the drilling point.

8. A system as claimed in Claim 7, **characterized in that** said pressure members (29) are activated individually by said corresponding actuating means (30) via corresponding motion transmission means (31) for generating a predetermined force-travel ratio of the corresponding pressure member (29) on said workpiece (8).

9. A system as claimed in one of Claims 2 to 8, wherein said spindle (9) is carried by a machining head (12) running along a cross member (33, 41) fitted to said fixed frame (6); **characterized in that** said supporting member (28, 36) comprises two parallel bars (39); each of said bars (39) supporting a number of pressure members (29).

10. A system as claimed in Claims 7 and 9, wherein said worktable (7) supports a number of workpieces (8) for drilling; and said cross member (41) supports in sliding manner a group of machining heads (12a, 12b, ..., 12n) having corresponding tool spindles (9) for drilling said workpieces (8); **characterized in that** said control unit (16) activates at least one of said pressure members (29a, 29b, ..., 29n) for each of said machining heads (12a, 12b, ..., 12n) so as to maintain the relative pressure on said workpieces (8) during the corresponding machining operation.
